# EUROPEAN PATENT APPLICATION

(11) **EP 1 796 233 A1**
(43) Date of publication of application: **13.06.2007**
(21) Application number: 05783175.2
(22) Date of filing: 13.09.2005
(51) Int. Cl.: H01S 5/22

(54) **SEMICONDUCTOR LASER ELEMENT AND SEMICONDUCTOR LASER ELEMENT ARRAY**

(30) Priority: 14.09.2004 JP 2004267422
(71) Applicant: HAMAMATSU PHOTONICS K.K., Hamamatsu-shi, Shizuoka-ken 435-8558 (JP)
(72) Inventor: Wang, You, Hamamatsu Photonics K.K., Hamamatsu-shi, Shizuoka, 4358558 (JP); Miyajima, Hirofumi, Hamamatsu Photonics K.K., Hamamatsu-shi, Shizuoka, 4358558 (JP); Watanabe, Akiyoshi, Hamamatsu Photonics K.K., Hamamatsu-shi, Shizuoka, 4358558 (JP); Kan, Hirofumi, Hamamatsu Photonics K.K., Hamamatsu-shi, Shizuoka, 4358558 (JP)
(74) Representative: Frost, Alex John
(86) International application number: PCT/JP2005/016833
(87) International publication number: WO 2006/030778

(57) **Abstract**

A semiconductor laser device 3 includes an n-type clad layer 13, an active layer 15, and a p-type clad layer 17. The p-type clad layer 17 has a ridge portion 9 that forms a waveguide 4 in the active layer 15. The waveguide 4 extends along a central axial line B that is curved at a substantially constant curvature (curvature radius R). In such a waveguide 4, of the light components that resonate inside the waveguide 4, light components of higher spatial transverse mode order are greater in loss. Laser oscillations of high-order transverse modes can thus be suppressed while maintaining laser oscillations of low-order transverse modes. A semiconductor laser device and a semiconductor laser device array, which can emit laser light of comparatively high intensity and with which high-order transverse modes can be suppressed, are thereby realized.

## Description

### Technical Field

The present invention relates to a semiconductor laser device and a semiconductor laser device array.

### Background Art

Spatial transverse single-mode and multi-mode structures have been known as structures of conventional semiconductor laser devices. Among these, with a single mode type semiconductor laser device, a waveguide is formed to be narrow in width to restrict the oscillation mode in the transverse direction (slow axis direction) within the waveguide to a single-mode. However, when the width of the waveguide is narrow, an emission end is also made small in area. Also, when the laser light density at the emission end is excessive, the reliability, etc., of the semiconductor laser device are affected. Single-mode type semiconductor laser devices are thus favorably employed in applications using laser light of comparatively low output. As an example of a single-mode type semiconductor laser device, there is the semiconductor laser apparatus disclosed in Patent Document 1 (Japanese Patent Application Laid-Open No. H10-41582). With this semiconductor laser apparatus, the width of a waveguide in a single-mode type semiconductor laser is expanded to increase the laser light intensity.

Meanwhile, with a multi-mode type semiconductor laser device, because a plurality of spatial transverse modes may coexist inside a waveguide, the waveguide can be formed to be wide in width. An emission end can thus be made large in area and laser light of comparatively high intensity can be emitted. Such multi-mode type semiconductor laser devices are favorably employed in applications requiring laser light of comparatively high output.
Patent Document 1: Japanese Patent Application Laid-Open No. H10-41582

### Disclosure of the Invention

### Problems to be Solved by the Invention

However, multi-mode type semiconductor laser devices have the following problems. That is, because a plurality of transverse spatial modes coexist inside the waveguide, the emission pattern of laser light emitted from the emission end is disordered and the emission angle is comparatively large. A lens for converging or collimating this laser light thus becomes complex in shape, and there may thus be the demerit that the desired laser light may not be obtained or the lens is expensive. In order to suppress these demerits, it is preferable to suppress high-order transverse modes as much as possible.

The present invention has been made in view of the above problems, and an object thereof is to provide a semiconductor laser device and a semiconductor laser device array that can emit laser light of comparatively high intensity and can suppress high-order transverse modes.

### Means for Solving the Problems

To achieve the above object, a semiconductor laser device according to the present invention includes: a first conductive type clad layer; a second conductive type clad layer; an active layer, disposed between the first conductive type clad layer and the second conductive type clad layer; a light emitting surface and a light reflecting surface that oppose each other; and a waveguide, formed in the active layer and making laser light resonate between the light emitting surface and the light reflecting surface; and the waveguide extends along a curved axial line.

In such a waveguide, among light components resonating inside the waveguide, light components of higher spatial transverse mode order are greater in loss. Thus with this semiconductor laser device, laser oscillations of high-order transverse modes can be suppressed while maintaining laser oscillations of low-order transverse modes, thereby enabling beam quality characteristics, such as spatial coherence characteristics in the transverse direction, to be improved. Also with this semiconductor laser device, because unlike a conventional single-mode type device, high-order transverse modes are suppressed by curving the waveguide, the width of the waveguide can be made wider. Laser light of a comparatively high intensity can thus be emitted.

The semiconductor laser device array according to the present invention is characterized in having a plurality of semiconductor laser devices of the above-described arrangement and in that the plurality of semiconductor laser devices are aligned and formed integrally in a direction along the light emitting surface and the light reflecting surface.

With the above-described semiconductor laser device array, by having the plurality of semiconductor laser devices described above, a semiconductor laser device array, which can emit laser light of comparatively high intensity and with which high-order transverse modes can be suppressed, can be provided.

### Effects of the Invention

By the present invention, a semiconductor laser device and a semiconductor laser device array, which can emit laser light of comparatively high intensity and with which high-order transverse modes can be suppressed, can be provided.

### Brief Description of the Drawings

[FIG. 1] FIG. 1 is a schematic perspective view of an arrangement of a first embodiment of a semiconductor laser device array according to the present invention.
[FIG. 2] FIG. 2 is an enlarged sectional view of a section taken on line I-I of the semiconductor laser device array of FIG. 1.
[FIG 3] FIG. 3 is a perspective view of a laminate including a p-type clad layer.
[FIG 4] FIG 4 is a figure including (a) a plan view of the laminate and (b) a sectional view of a section taken on line II-II of the laminate.
[FIG. 5] FIG. 5 is a plan view of a shape of a waveguide formed in correspondence to a ridge portion.
[FIG 6] FIG. 6 is a graph of correlations between the curvature radius of a curved waveguide and loss of light components that propagate inside the waveguide.
[FIG 7] FIG. 7 is a graph of correlations between the curvature radius of a curved waveguide and loss of light components that propagate inside the waveguide.
[FIG. 8] FIG. 8 shows enlarged sectional views of the semiconductor laser device array in respective manufacturing steps.
[FIG. 9] FIG. 9 is a plan view of a waveguide of a semiconductor laser device according to a first modification example.
[FIG 10] FIG. 10 is a plan view of a waveguide of a semiconductor laser device according to a second modification example.
[FIG. 11] FIG. 11 is a plan view of a waveguide of a semiconductor laser device according to a third modification example.

### Description of the Symbols

1 - semiconductor laser device array, 1a - light emitting surface, 1b - light reflecting surface, 3 - semiconductor laser device, 4 - waveguide, 4e - laser light emitting end, 4f - laser light reflecting end, 4g, 4h - side surface, 8 - laminate, 9 - ridge portion, 9e, 9f - end surface, 9g, 9h - side surface, 10 - thin region, 11 - substrate, 13 - n-type clad layer, 15 - active layer, 17 - p-type clad layer, 19 - cap layer, 21 - insulating layer, 21a - opening, 23 - p-side electrode layer, 25 - protruding portion, 29 - n-side electrode layer, 51 - protective mask.

### Best Modes for Carrying Out the Invention

Embodiments of a semiconductor laser device and a semiconductor laser device array according to the present invention shall now be described in detail with reference to the attached drawings. In the description of the drawings, portions that are the same shall be provided with the same symbol and overlapping description shall be omitted.

(First Embodiment)

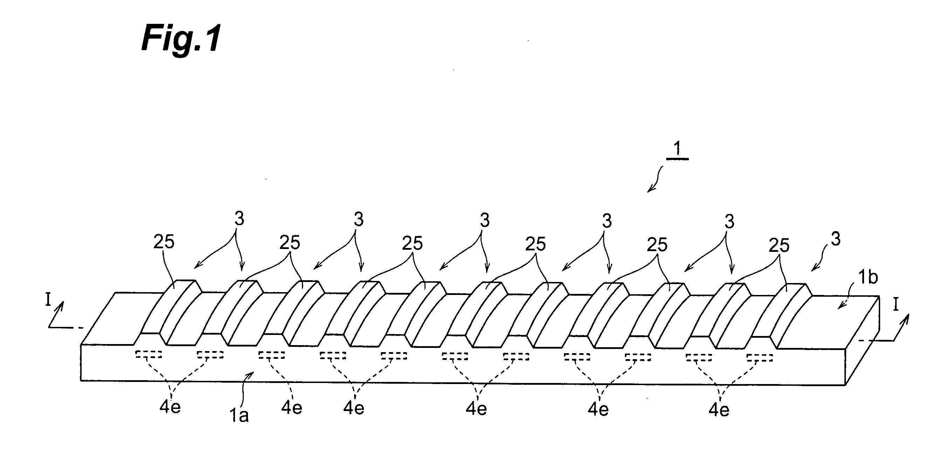

FIG. 1 is a schematic perspective view of an arrangement of a first embodiment of a semiconductor laser device array according to the present invention. As shown in FIG. 1, the semiconductor laser device array 1 is constituted of a plurality of integrally formed semiconductor laser devices 3. Though the number of the semiconductor laser devices 3 that the semiconductor laser device array 1 has may be any number, when there is only one laser device, the arrangement is not an array but a single semiconductor laser device. The semiconductor laser device array 1 has a light emitting surface 1a and a light reflecting surface 1b that oppose each other, and respective laser light emitting ends 4e of the plurality of semiconductor laser devices 3 are disposed along a horizontal direction on the light emitting surface 1a. Each of the plurality of semiconductor laser devices 3 has a protruding portion 25 that is formed to a ridge-like form. Each protruding portion 25 extends from the light emitting surface 1a to the light reflecting surface 1b and, in its longitudinal direction, each protruding portion 25 is curved in a direction along the light emitting surface 1a and the light reflecting surface 1b. In each semiconductor laser device 3, a refractive index type waveguide (to be described later) is formed in correspondence to the protruding portion 25. The laser light emitting end 4e is an end surface at the light emitting surface 1a side of the refractive index type waveguide. The plurality of semiconductor laser devices 3 are aligned and formed integrally in the direction along the light emitting surface 1a and the light reflecting surface 1b.

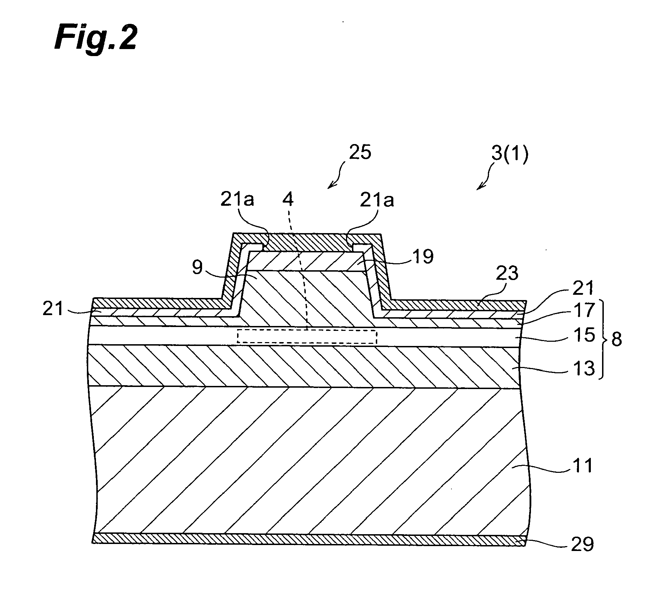

FIG. 2 is an enlarged sectional view of a section taken on line I-I of the semiconductor laser device array 1 of FIG. 1. Referring now to FIG 2, each of the semiconductor laser devices 3 that constitute the semiconductor laser device array 1 has a substrate 11 and a laminate 8, in which three semiconductor layers are laminated. The laminate 8 is formed by successively laminating the three semiconductor layers of an n-type clad layer (second conductive type clad layer) 13, an active layer 15, and a p-type clad layer (first conductive type clad layer) 17. The p-type clad layer 17 is provided with a ridge portion 9. A cap layer 19, which is electrically connected to the p-type clad layer 17, is provided at an outer layer of the ridge portion 9, and each protruding portion 25 is formed from the ridge portion 9 and the cap layer 19.

A p-side electrode layer 23, by which a current is injected from the exterior, is disposed at a further outer layer. An insulating layer 21 is disposed between the p-side electrode layer 23 and the p-type clad layer 17 and cap layer 19, and the insulating layer 21 has an opening 21a at a portion corresponding to the protruding portion 25. Because the p-side electrode layer 23 electrically contacts only the cap layer 19 at the opening 21a, the injection of current from the exterior is restricted just to the cap layer 19. Also, an n-side electrode layer 29 is formed on a surface of the substrate 11 at the side opposite the laminate 8. To give examples of respective component materials, the substrate 11 is formed, for example, of n-GaAs. The n-type clad layer 13 is formed, for example, ofn-AIGaAs. The active layer 15 is formed, for example, of GaInAs/AIGaAs. The p-type clad layer 17 is formed, for example, of p-AlGaAs. The cap layer 19 is formed, for example, of p-GaAs. The p-side electrode layer 23 is formed, for example, of Ti/Pt/Au. The n-side electrode layer 29 is formed, for example, of AuGe/Au. The insulating layer 21 is formed, for example, of SiN.

When a current is injected into the cap layer 19, a region of the active layer 15 corresponding to the protruding portion 25 (in other words, a region corresponding to the ridge portion 9) becomes an active region. In this process, because an effective refractive index difference arises in the active layer 15 due to the refractive index difference between the ridge portion 9 and its exterior, a waveguide 4 is formed inside the active layer 15 in correspondence to the protruding portion 25. The semiconductor laser device may have optical guide layers, for containment of light in the refractive index type waveguide, between the active layer and the n-type clad layer and between the active layer and the p-type clad layer.

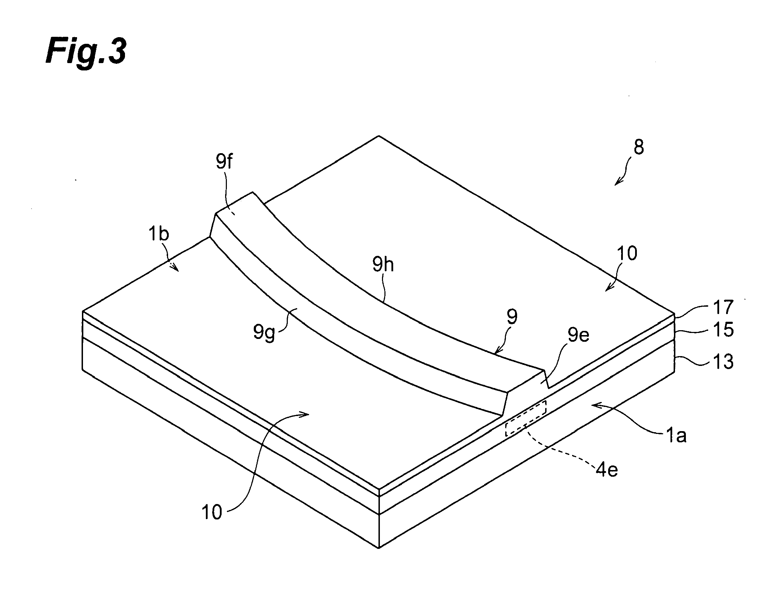

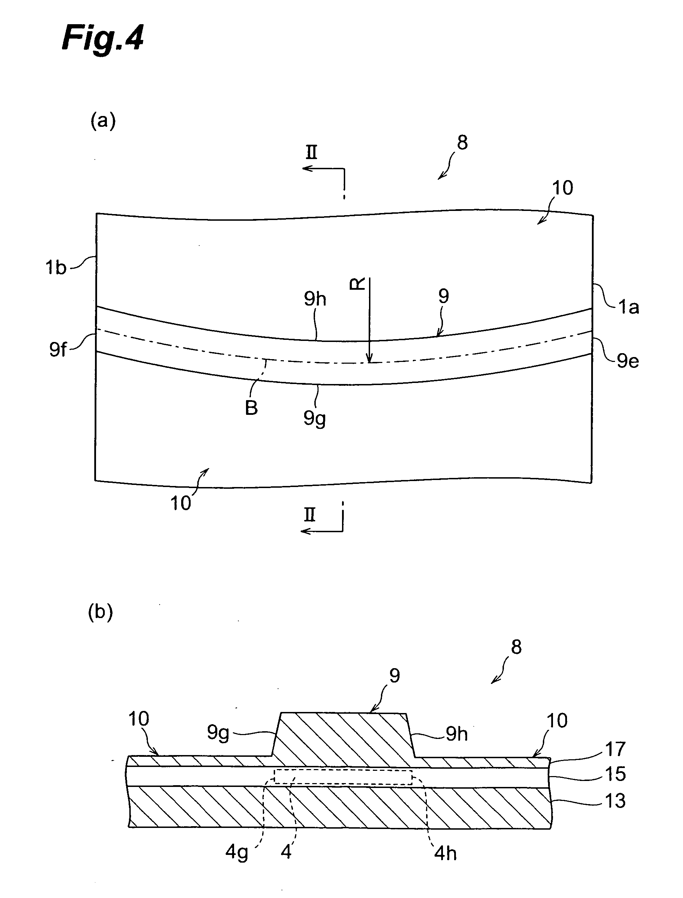

The p-type clad layer 17 shall now be described with reference to FIGS. 3 and 4. FIG. 3 is a perspective view of the laminate 8 including the p-type clad layer 17, (a) in FIG. 4 is a plan view of the laminate 8, and (b) in FIG. 4 is a sectional view of a section taken on line II-II of the laminate 8 of FIG. 4(a). As mentioned above, the laminate 8 is formed by successively laminating the three semiconductor layers of the n-type clad layer 13, the active layer 15, and the p-type clad layer 17.

The protruding ridge portion 9, which extends between the light emitting surface 1a and the light reflecting surface 1b, is formed in the p-type clad layer 17. The regions of the p-type clad layer 17 besides the ridge portion 9 are thin regions 10, with which the layer is thinned. The shape in plan view of the ridge portion 9 is an arc-like shape, with which a direction along a central axial line B that is curved at a substantially constant curvature radius R is the longitudinal direction.

The ridge portion 9 has end surfaces 9e and 9f and a pair of mutually opposing side surfaces 9g and 9h. Each of the pair of side surfaces 9g and 9h defines the region of the ridge portion 9 and is a boundary between the ridge portion 9 and the thin region 10. The end surface 9e is disposed on the light emitting surface 1a. The end surface 9f is disposed on the light reflecting surface 1b. The side surface 9g extends from one end of the end surface 9e to one end of the end surface 9f, and the side surface 9h extends from the other end of the end surface 9e to the other end of the end surface 9f. The side surfaces 9g and 9h are respectively curved in the same direction at the substantially constant curvature radius so as to be aligned along the central axial line B in plan view as viewed from a thickness direction.

The refractive index type waveguide 4, corresponding to the shape of the ridge portion 9, is formed in the active layer 15. The waveguide 4 is formed by an effective refractive index distribution in the interior of the active layer 15 that results from the injection of current into the ridge portion 9. With the waveguide 4, the laser light emitting end 4e and a laser light reflecting end (to be described below) are formed in correspondence to the end surfaces 9e and 9f of the ridge portion 9, and a pair of side surfaces 4g and 4h are formed in correspondence to the side surfaces 9g and 9h of the ridge portion 9.

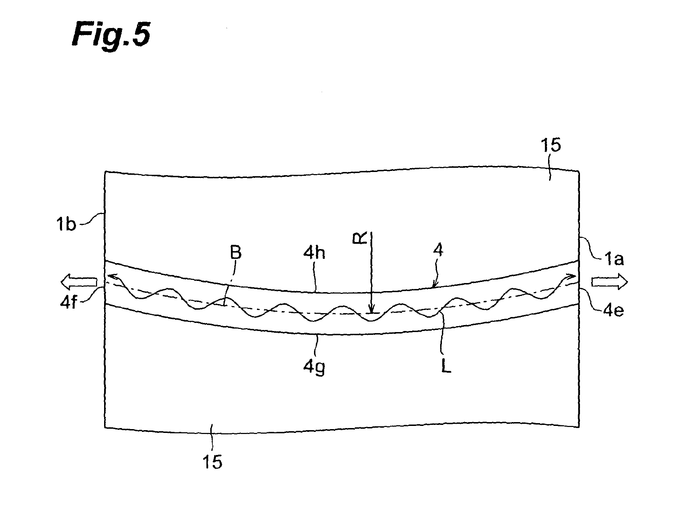

FIG. 5 is a plan view of the shape of the waveguide 4 that is formed in correspondence to the ridge portion 9. The waveguide 4 is defined in the thickness direction by a boundary surface between the active layer 15 and the p-type clad layer 17 and a boundary surface between the active layer 15 and the n-type clad layer 13. The waveguide 4 has the laser light emitting end 4e and the laser light reflecting end 4f respectively at positions corresponding to the end surface 9e and the end surface 9f of the ridge portion 9. The laser light emitting end 4e and the laser light reflecting end 4f are portions of cleavage surfaces of the active layer 15 and function as resonance surfaces for laser light L.

Also, the longitudinal direction of the waveguide 4 is curved in correspondence to the ridge portion 9. That is, the waveguide 4 extends along the central axial line B with the curvature radius R and has the side surfaces 4g and 4h respectively at positions corresponding to the side surfaces 9g and 9h of the ridge portion 9. Here, the side surfaces 4g and 4h are surfaces formed by a refractive index difference between the interior and the exterior of the waveguide 4 and function as reflecting surfaces for the laser light L generated inside the waveguide 4. When the refractive index inside and outside the waveguide 4 varies continuously, each of the side surfaces 4g and 4h may have a certain, fixed thickness. The planar shapes of the side surfaces 4g and 4h correspond to the planar shapes of the side surfaces 9g and 9h of the ridge portion 9. That is, the planar shapes of the side surfaces 4g and 4h are curved in the same direction (direction along the light emitting surface 1a and the light reflecting surface 1b) at the substantially constant curvature radius along the central axial line B.

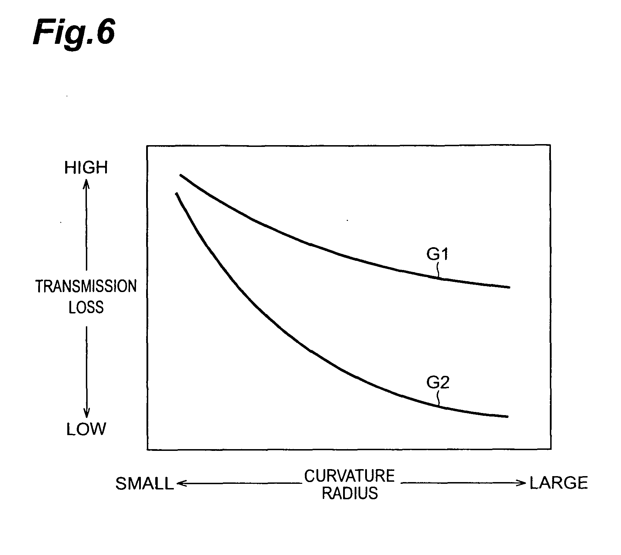

Here, FIG. 6 is a graph of correlations between the curvature radius of a curved waveguide and loss of light components that propagate inside the waveguide. In FIG. 6, graph G1 indicates the loss in a spatial transverse mode of comparatively high order, and graph G2 indicates the loss in a spatial transverse mode of comparatively low order. The wavelength of light is the same for the respective graphs G1 and G2 in FIG. 6.

As shown in FIG. 6, in a curved waveguide, there is a trend for the loss to be greater the higher the order of the spatial transverse mode of light that propagates inside the waveguide. Thus by the waveguide 4 extending along the curved central axial line B, the optical loss is made higher and laser oscillation is made more difficult the higher the order of a spatial transverse mode. Thus with the semiconductor laser device 3 of the present embodiment, laser oscillations of high-order transverse modes can be suppressed while maintaining laser oscillations of low-order transverse modes, thereby enabling beam quality characteristics, such as spatial coherence characteristics in the transverse direction, to be improved. Also, because there is a trend that the smaller the curvature radius of the waveguide the greater the losses of the respective modes, by setting the curvature radius of the central axial line B so that only laser light of a fundamental transverse mode resonates and light of other modes cannot resonate, laser light of a single-mode or laser light close to a single-mode can be realized.

Also with the semiconductor laser device 3 according to the present embodiment, because, unlike a conventional single-mode type laser device, high-order transverse mode light components are suppressed by making the waveguide 4 curved, the width of the waveguide 4 can be made wider. Laser light L of a comparatively high intensity can thus be emitted.

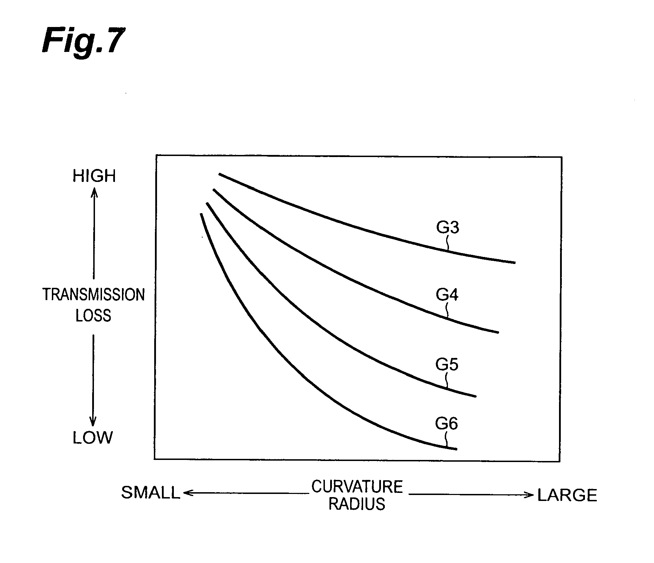

In setting the curvature radius of the central axial line B, the variation of loss according to waveguide width should also be considered. For example, FIG. 7 is a graph of correlations between the curvature radius of a curved waveguide and loss of light components that propagate inside the waveguide, and graphs G3 to G6 indicate losses of light propagating inside waveguides of mutually different waveguide widths w₁ to w₄ (W₁>W₂>W₃>W₄). The spatial transverse mode order is the same for the respective graphs G3 to G6 of FIG 7. As shown in FIG 7, the wider the waveguide width, the greater the loss of light that propagates inside the waveguide. Thus in designing a waveguide, the curvature radius R and the waveguide width of the waveguide 4 should be determined based on the correlations shown in FIGS. 6 and 7 so that the losses of low-order transverse modes are made low enough to enable laser oscillation and yet the losses of high-order transverse modes are made high enough to disable laser oscillation. To give an example, to realize laser light of a single-mode or close to a single-mode, the curvature radius R is set so that 1mm≥R≥10mm and the waveguide width w is set so that 0.03mm≥w≥0.1mm.

Also with the semiconductor laser device 3 according to the present embodiment, the effects described below are provided in addition to the effects described above. That is, preferably the curvature of the central axial line B is substantially fixed (curvature radius R) across the entirety of the waveguide 4 as in the present embodiment. Because the boundary between the spatial transverse modes for which resonance occurs and the spatial transverse modes for which resonance is suppressed is thereby made uniform across the entirety of the waveguide 4, laser oscillations of high-order transverse modes in the waveguide 4 can be suppressed more effectively.

Also with the semiconductor laser device array 1 according to the present embodiment, by being equipped with the plurality of semiconductor laser devices 3 that provide the above-described effects, the laser light L, with which oscillations of high-order transverse modes are suppressed, can be emitted at a higher intensity.

The semiconductor laser device array 1 according to the present embodiment furthermore provides the following effects. That is, with the semiconductor laser device array 1, current is made to be injected concentratingly into portions of the active layer 15 by the ridge portions 9 of the p-type clad layer 17. Coupling and interference of light between the waveguides 4 of adjacent semiconductor laser devices 3 thus do not occur readily. Because the mutual interval between the waveguides 4 can thereby be made comparatively narrow, a larger number of the waveguides 4 can be disposed to enable emission of stable laser light at high output. Furthermore, by current being injected concentratingly into portions of the active layer 15, the electricity/light conversion efficiency is increased, and because the reactive current can be decreased, heat generation by the semiconductor laser devices 3 can be reduced. The semiconductor laser device array 1 can thus be made high in reliability and long in life.

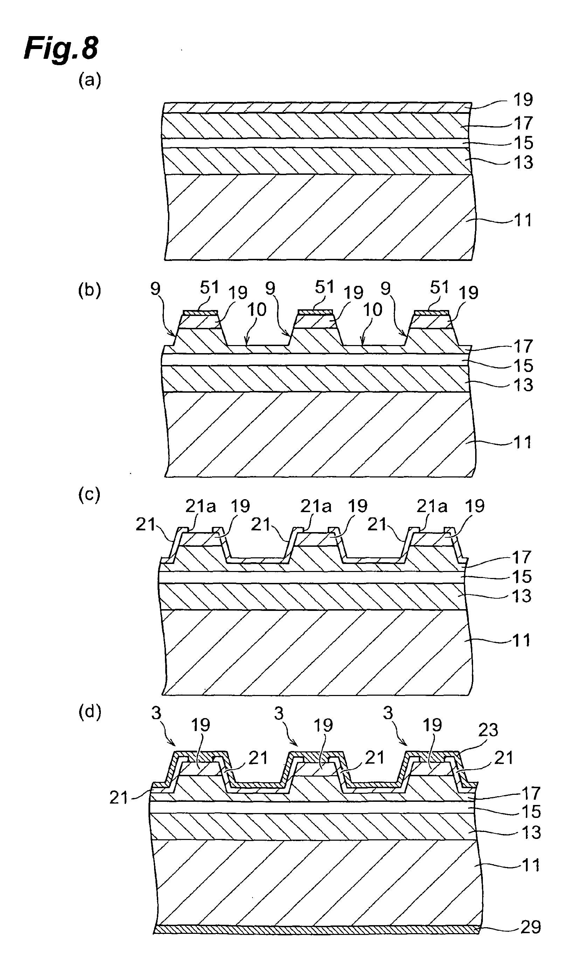

A method for manufacturing the semiconductor laser device array 1 shall now be described with reference to FIG. 8. FIG. 8 shows enlarged sectional views of the semiconductor laser device array 1 in respective manufacturing steps. First, an n-type GaAs substrate 11 is prepared, and then 2.0µm of n-type AlGaAs, 0.3µm of GaInAs/AlGaAs, 2.0µm of p-type AlGaAs, and 0.1µm of p-type GaAs are epitaxially grown successively on the substrate 11, thereby respectively forming the n-type clad layer 13, the active layer 15, having a quantum well structure, the p-type clad layer 17, and the cap layer 19 (see (a) in FIG. 8).

Protective masks 51 are then formed to shapes corresponding to the ridge portions 9 by photo-working on the cap layer 19 side, and the cap layer 19 and the p-type clad layer 17 are etched. The etching is stopped at a depth that does not reach the active layer 15 (see (b) in FIG. 8). An SiN film is then deposited on the entire crystal surface, and portions of the SiN film at positions corresponding to the ridge portions 9 are removed by photo-working to form the insulating layers 21 (see (c) in FIG 8). The p-side electrode layer 23 is then formed over the entire crystal surface from a Ti/Pt/Au film. Polishing and chemical treatment of the surface of the substrate 11 side are then performed, and the n-side electrode layer 29 is formed from AuGe/Au (see (d) in FIG 8). The semiconductor laser device array 1 (semiconductor laser devices 3) is thereby completed.

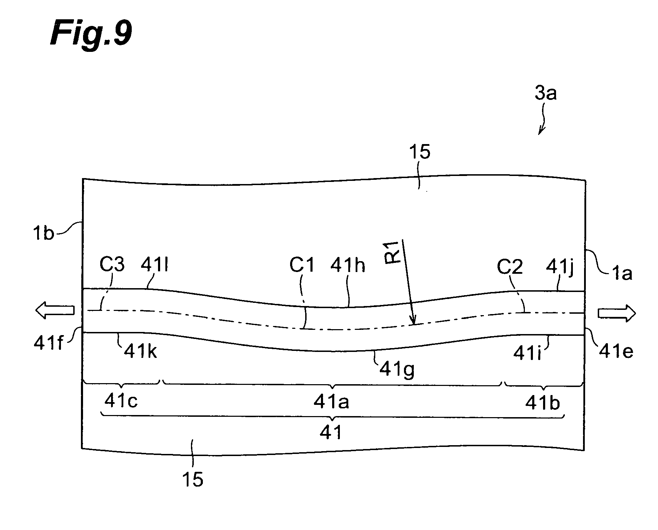

(First Modification Example)
A first modification example of the semiconductor laser device array 1 (semiconductor laser device 3) according to the first embodiment shall now be described. FIG. 9 is a plan view of a waveguide 41 of a semiconductor laser device 3a according to the present modification example. This waveguide 41 differs in planar shape from the waveguide 4 according to the first embodiment. That is, the waveguide 41 is constituted of a curved portion 41a, a waveguide portion 41 b, formed between one end of the curved portion 41 a and the light emitting surface 1 a, and a waveguide portion 41 c, formed between the other end of the curved portion 41 a and the light reflecting surface 1b. The longitudinal direction of the curved portion 41 a is arranged along a central axial line C1 that is curved at a substantially constant curvature (curvature radius R1). The waveguide portion 41b is in contact with the light emitting surface 1a and the longitudinal direction thereof is arranged along a straight central axial line C2 that is substantially perpendicular to the light emitting surface 1a. The waveguide portion 41 c is in contact with the light reflecting surface 1b and the longitudinal direction thereof is arranged along a straight central axial line C3 that is substantially perpendicular to the light reflecting surface 1b. The central axial lines C1 to C3 are connected smoothly at their mutual boundary portions.

The curved portion 41a has a pair of mutually opposing side surfaces 41h and 41g. The waveguide portion 41b has a pair of mutually opposing side surfaces 41i and 41j. The waveguide portion 41c has a pair of mutually opposing side surfaces 41k and 411. One end of the side surface 41g of the curved portion 41 a is connected smoothly to one end of the side surface 41i of the waveguide portion 41b, and the other end is connected smoothly to one end of the side surface 41k of the waveguide portion 41 c. One end of the side surface 41h of the curved portion 41 a is connected smoothly to one end of the side surface 41j of the waveguide portion 41b, and the other end is connected smoothly to one end of the side surface 411 of the waveguide portion 41 c. The other end of the side surface 41i of the waveguide portion 41 b is in contact with one end of a laser light emitting end 41 e, and the other end of the side surface 41j is in contact with the other end of the laser light emitting end 41e. The other end of the side surface 41k of the waveguide portion 41c is in contact with one end of a laser light reflecting end 41f, and the other end of the side surface 411 is in contact with the other end of the laser light reflecting end 41f. The laser light emitting end 41e and the laser light reflecting end 41f are portions of the light emitting surface 1a and the light reflecting surface 1b, respectively, and are resonance surfaces for laser light.

The side surfaces 41g and 41h of the curved portion 41a are respectively curved in the same direction at a substantially constant curvature along the central axial line C1. The side surfaces 41 and 41j of the waveguide portion 41b extend straightly along the central axial line C2 and contact the laser light emitting end 41e (light emitting surface 1a) substantially perpendicularly. The side surfaces 41k and 411 of the waveguide portion 41c extend straightly along the central axial line C3 and contact the laser light reflecting end 41f (light reflecting surface 1b) substantially perpendicularly. In the present modification example, the waveguide 41 of such a shape is realized by a p-type clad layer having a ridge portion of the same planar shape.

With the waveguide of the present invention, by a curved portion being included at least in a portion of the waveguide as in the waveguide 41 of the present modification example, the same effects as those of the above-described first embodiment can be obtained. That is, with the waveguide 41 of the present modification example, the higher the order of the spatial transverse mode of light propagating inside the waveguide, the greater the loss in the curved portion 41 a. Laser oscillations of high-order transverse modes can thus be suppressed while maintaining laser oscillations of low-order transverse modes, thereby enabling beam quality characteristics, such as spatial coherence characteristics in the transverse direction, to be improved. Also, by setting the curvature radius of the central axial line C1 so that only laser light of a fundamental transverse mode resonates and light of other modes cannot resonate, laser light of a single-mode or laser light close to a single-mode can be realized.

Furthermore with the semiconductor laser device 3a according to the present modification example, because, unlike a conventional single-mode type laser device, high-order transverse mode light components are suppressed by making a portion of the waveguide 41 curved, the width of the waveguide 41 can be made wider. Laser light of a comparatively high intensity can thus be emitted.

Also the waveguide 41 of the present modification example has the waveguide portion 41b, which extends along the central axial line C2 substantially perpendicular to the light emitting surface 1a, at a portion contacting the light emitting surface 1a. Or, the waveguide 41 has the waveguide portion 41c, which extends along the central axial line C3 substantially perpendicular to the light reflecting surface 1b, at a portion contacting the light reflecting surface 1b. By the waveguide 41 thus having the waveguide portion 41b (or 41c) that extends substantially perpendicular to the light emitting surface 1a (or the light reflecting surface 1b), laser oscillations of high-order transverse modes in directions that differ from the direction substantially perpendicular to the light emitting surface 1a (or the light reflecting surface 1b) can be suppressed effectively.

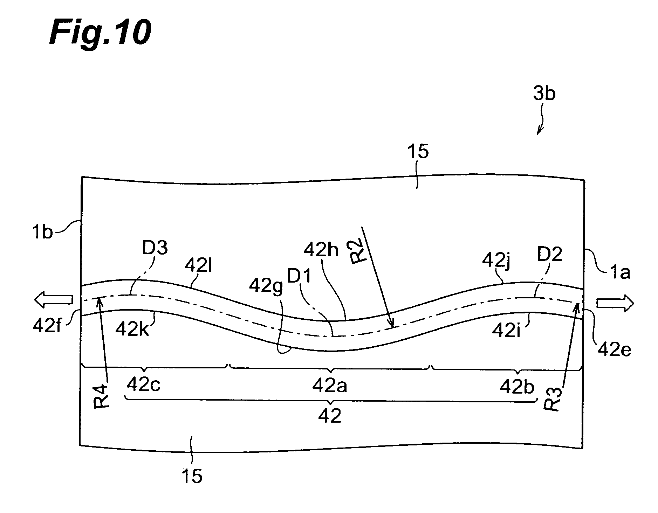

(Second Modification Example)
A second modification example of the semiconductor laser device array 1 (semiconductor laser device 3) according to the first embodiment shall now be described. FIG. 10 is a plan view of a waveguide 42 of a semiconductor laser device 3b according to the present modification example. This waveguide 42 differs in planar shape from the waveguide 4 according to the first embodiment. That is, the waveguide 42 is constituted of a curved portion 42a, a curved portion 42b, formed between one end of the curved portion 42a and the light emitting surface 1a, and a curved portion 42c, formed between the other end of the curved portion 42a and the light reflecting surface 1b. The curved portion 42a is an example of a first curved portion in the present invention, and curved portions 42b and 42c are examples of second curved portions in the present modification example. The longitudinal directions of the curved portions 42a to 42c are respectively arranged along central axial lines D1 to D3, which are curved at substantially constant curvatures (curvature radii R2 to R4). The central axial lines D2 and D3 are curved in a direction that differs from (in the present modification example, the direction opposite) the direction in which the central axial line D1 is curved. The longitudinal directions of the curved portions 42b and 42c are thus curved in a direction that differs from the longitudinal direction of the curved portion 42a. The mutual boundary portions of the central axial lines D1 to D3 are connected smoothly so that the mutual tangent lines are matched.

The curved portion 42a has a pair of mutually opposing side surfaces 42h and 42g. The curved portion 42b has a pair of mutually opposing side surfaces 42i and 42j. The curved portion 42c has a pair of mutually opposing side surfaces 42k and 421. One end of the side surface 42g of the curved portion 42a and one end of the side surface 42i of the curved portion 42b are connected so that the mutual tangent lines at the connecting portion are matched. Likewise, the other end of the side surface 42g and one end of the side surface 42k of the curved portion 42c are connected so that the mutual tangent lines at the connecting portion are matched. One end of the side surface 42h of the curved portion 42a and one end of the side surface 42j of the curved portion 42b are connected so that the mutual tangent lines at the connecting portion are matched. The other end of the side surface 42h and one end of the side surface 421 of the curved portion 42c are connected so that the mutual tangent lines at the connecting portion are matched. The other end of the side surface 42i of the curved portion 42b is in contact with one end of a laser light emitting end 42e, and the other end of the side surface 42j is in contact with the other end of the laser light emitting end 42e. The other end of the side surface 42k of the curved portion 42c is in contact with one end of a laser light reflecting end 42f, and the other end of the side surface 421 is in contact with the other end of the laser light reflecting end 42f. The laser light emitting end 42e and the laser light reflecting end 42f are portions of the light emitting surface 1a and the light reflecting surface 1b, respectively, and are resonance surfaces for laser light.

The side surfaces 42g and 42h of the curved portion 42a are respectively curved in the same direction at a substantially constant curvature along the central axial line D1. The side surfaces 42i and 42j of the curved portion 42b are respectively curved in the same direction (direction opposite the direction in which the side surfaces 42g and 42h are curved) at a substantially constant curvature along the central axial line D2. The side surfaces 42k and 421 of the curved portion 42c are respectively curved in the same direction (direction opposite the direction in which the side surfaces 42g and 42h are curved) at a substantially constant curvature along the central axial line D3. In the present modification example, the waveguide 42 of such a shape is realized by a p-type clad layer having a ridge portion of the same planar shape.

As in the waveguide 42 of the present modification example, by the waveguide 42 including the curved portions 42a and 42b (or 42c) that extend along the central axial lines D1 and D2 (or D3) that are curved in mutually different directions, the effects of the above-described first embodiment can be obtained even more favorably. That is, with the waveguide 42 of the present modification example, by including the plurality of curved portions 42a to 42c, high-order transverse modes can be suppressed even more effectively. Also, by the central axial lines D1 and D2 (or D3) of the curved portions 42a and 42b (or 42c) being curved in mutually different directions, the high-order transverse modes can be suppressed with greater stability. Also, because the waveguide width can be made wider with the waveguide 42 of the present modification example as well, laser light of a comparatively high intensity can be emitted. Although the waveguide 42 is arranged to include the three curved portions 42a to 42c in the present modification example, the waveguide may include any number of curved portions.

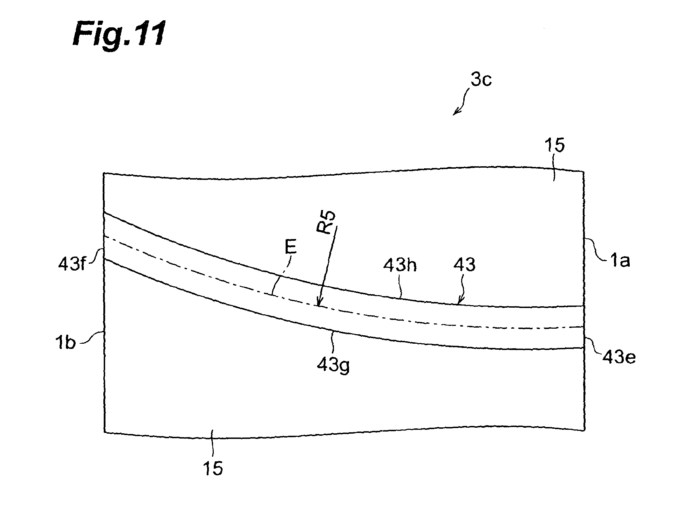

(Third Modification Example)
A third modification example of the semiconductor laser device array 1 (semiconductor laser device 3) according to the first embodiment shall now be described. FIG. 11 is a plan view of a waveguide 43 of a semiconductor laser device 3c according to the present modification example. The longitudinal direction of the waveguide 43 in the present modification example extends along a central axial line E that is curved at a substantially constant curvature (curvature radius R5). The central axial line E in the present modification example differs from the central axial line B in the above-described first embodiment in the relative positional relationship of a point of intersection of the light emitting surface 1a and the central axial line E (that is, the center of a laser light emitting end 43e) and a point of intersection of the light reflecting surface 1b and the central axial line E (that is, the center of a laser light reflecting end 43f). Referring now to FIG. 5, with the waveguide 4 of the first embodiment, a point of intersection of the light emitting surface 1a and the central axial line B (that is, the center of the laser light emitting end 4e) and a point of intersection of the light reflecting surface 1b and the central axial line B (that is, the center of a laser light reflecting end 4f) are positioned substantially symmetrical to each other. In contrast, with the present modification example shown in FIG. 11, the point of intersection of the light emitting surface 1a and the central axial line E and the point of intersection of the light reflecting surface 1b and the central axial line E are mutually shifted from symmetrical positions. Here, symmetrical positions shall refer to positions that are plane symmetrical across a plane that is parallel to the light emitting surface 1a and the light reflecting surface 1b and is positioned at a center of these surfaces.

The waveguide 43 has a pair of mutually opposing side surfaces 43g and 43h. One end of the side surface 43g of the waveguide 43 is in contact with one end of the laser light emitting end 43e, and one end of the side surface 43h is in contact with the other end of the laser light emitting end 43e. The other end of the side surface 43g of the waveguide 43 is in contact with one end of the laser light reflecting end 43f, and the other end of the side surface 43h is in contact with the other end of the laser light reflecting end 43f. The side surfaces 43g and 43h of the waveguide 43 are respectively curved in the same direction at a substantially constant curvature along the central axial line E. In the present modification example, a contact point of the side surface 43g of the waveguide 43 and the laser light emitting end 43e (or a contact point of the side surface 43h of the waveguide 43 and the laser light emitting end 43e) and a contact point of the side surface 43g of the waveguide 43 and the laser light reflecting end 43f (or a contact point of the side surface 43h of the waveguide 43 and the laser light reflecting end 43f) are mutually shifted in position from symmetrical positions. The laser light emitting end 43e and the laser light reflecting end 43f are portions of the light emitting surface 1a and the light reflecting surface 1b, respectively, and are resonance surfaces for laser light. In the present modification example, the waveguide 43 of such a shape is realized by a p-type clad layer having a ridge portion of the same planar shape.

As with the waveguide 43 of the present modification example, with the waveguide in the present invention, the position of the laser light emitting end 43e and the position of the laser light reflecting end 43f may be asymmetrical with respect to each other. The same effects as those of the above-described first embodiment can be obtained by such a waveguide 43 as well.

The semiconductor laser device and the semiconductor laser device array according to the present invention is not restricted to the embodiment and the modification examples described above and various other modifications are possible. For example, although a GaAs-based semiconductor laser device was described with the embodiment above, the arrangement of the present invention can also be applied to semiconductor laser devices based on other materials, such as GaN, InP, etc. Also, although in each of the embodiment and modification examples described above, the central axial line is used as the axial line, the axial line is not restricted to the central axial line and may be an axial line that passes through a portion besides the center.

Here, preferably the semiconductor laser device includes: a first conductive type clad layer; a second conductive type clad layer; an active layer, disposed between the first conductive type clad layer and the second conductive type clad layer; a light emitting surface and a light reflecting surface that oppose each other; and a waveguide, formed in the active layer and making laser light resonate between the light emitting surface and the light reflecting surface; and the waveguide extends along a curved axial line.

With the semiconductor laser device, the curvature of the curved axial line may be substantially fixed. Also with the semiconductor laser device, the waveguide may include a plurality of curved portions and the curvature of the curved axial line may be substantially constant in each of the plurality of the curved portions. With these semiconductor laser devices, laser oscillations of high-order transverse modes can be suppressed more effectively.

Also with the semiconductor laser device, the waveguide may include first and second curved portions that extend along the curved axial lines that are curved in mutually different directions. Laser oscillations of high-order transverse modes can thereby be suppressed with higher in stability in the curved portions.

Also with the semiconductor laser device, the waveguide may include a waveguide portion that contacts the light emitting surface or the light reflecting surface and extends substantially perpendicular to the light emitting surface and the light reflecting surface. Laser oscillations of high-order transverse modes in directions that differ from the direction substantially perpendicular to the light emitting surface and the light reflecting surface can thereby be suppressed effectively.

The semiconductor laser device array preferably has a plurality of any of the above-described semiconductor laser devices and preferably, the plurality of semiconductor laser devices are disposed and formed integrally in a direction along the light emitting surface and the light reflecting surface.

With the above-described semiconductor laser device array, by having the plurality of any of the semiconductor laser devices described above, a semiconductor laser device array, which can emit laser light of comparatively high intensity and with which high-order transverse modes can be suppressed, can be provided.

### Industrial Applicability

The present invention can be used to provide a semiconductor laser device and a semiconductor laser device array, which can emit laser light of comparatively high intensity and with which high-order transverse modes can be suppressed.

## Claims

1. A semiconductor laser device comprising:
a first conductive type clad layer;
a second conductive type clad layer;
an active layer, disposed between the first conductive type clad layer and the second conductive type clad layer;
a light emitting surface and a light reflecting surface that oppose each other; and
a waveguide, formed in the active layer and making laser light resonate between the light emitting surface and the light reflecting surface;
wherein the waveguide extends along a curved axial line.

2. The semiconductor laser device according to Claim 1, wherein the curvature of the curved axial line is substantially constant.

3. The semiconductor laser device according to Claim 1, wherein the waveguide includes a plurality of curved portions; and
the curvature of the curved axial line is substantially constant in each of the plurality of the curved portions.

4. The semiconductor laser device according to Claim 3, wherein the waveguide includes first and second curved portions that extend along the curved axial lines that are curved in mutually different directions.

5. The semiconductor laser device according to any one of Claims 1 to 4, wherein the waveguide includes a waveguide portion that contacts the light emitting surface or the light reflecting surface and extends substantially perpendicular to the light emitting surface and the light reflecting surface.

6. A semiconductor laser device array comprising: a plurality of the semiconductor laser devices according to any one of Claims 1 to 5;
wherein the plurality of semiconductor laser devices are aligned and formed integrally in a direction along the light emitting surface and the light reflecting surface.
